# EUROPEAN PATENT APPLICATION

(11) **EP 4 790 894 A1**
(43) Date of publication of application: **12.08.2026**
(21) Application number: 26154171.8
(22) Date of filing: 26.01.2026
(51) Int. Cl.: H03F 1/02, H03F 3/72, H03F 3/195, H03F 3/21, H03F 3/60

(54) **AMPLIFIER CIRCUIT AND RELATED METHOD**

(30) Priority: 10.02.2025 IT 202500002490
(71) Applicant: STMicroelectronics International N.V., 1228 Plan-les-Ouates, Geneva (CH)
(72) Inventor: PAPOTTO, Giuseppe, I-95033 Biancavilla (Catania) (IT); PARISI, Alessandro, I-95126 Catania (IT); MINNELLA, Alessandro Domenico, I-95037 San Giovanni La Punta (Catania) (IT); PALMISANO, Giuseppe, I-95030 S.Giovanni La Punta (Catania) (IT)
(74) Representative: Buzzi, Notaro & Antonielli d'Oulx S.p.A.

(57) **Abstract**

An amplifier circuit based on Doherty amplifier architecture comprises a first signal splitter (13₁, 100₁) coupled to an input pre-amplifier (14) and configured to receive an input signal (RF_{IN}). The first signal splitter (13₁, 100₁) comprises a first passive splitter network (13₁) and a first splitter amplifier (100₁). The first passive splitter network (13₁) is configured to forward a first portion (α_{M}) of the input signal (RF_{IN}) towards a first amplifier (11) and a second portion (1-α_{M}) of the input signal (RF_{IN}) towards the first splitter amplifier (100₁). One or more secondary signal splitters (300) are provided, wherein the or each secondary signal splitter (300) is configured to receive a respective input signal coming from the first splitter amplifier (100₁) in the first signal splitter (13₁, 100₁) and comprises a passive secondary splitter network (300) configured to forward a first portion (α_{A1}) of the respective input signal towards a respective secondary amplifier (21) and a second portion (1-α_{A1}) of the respective input signal towards a respective further secondary amplifier (31). Combiner circuitry (200) provides at an output node (RF_{OUT}) an output signal resulting from a combination of an output signal from the first amplifier (11), the respective secondary amplifier (21), and the respective further secondary amplifier (31).

## Description

### Technical field

The description relates to amplifier circuits based on architecture currently referred to as Doherty amplifier.

One or more embodiments can be used, for instance, in power amplifiers for 5G applications.

### Description of the related art

A Doherty power amplifier (DPA) is a good candidate for various applications in so far as it provides an excellent trade-off between efficiency and linearity thanks to load modulation.

As discussed in the following, these features are particularly appreciated in 5G applications.

A conventional Doherty amplifier circuit consists of a main amplifier and an auxiliary amplifier which are fed by a power splitter driven by a preamplifier.

The circuit is configured to operate in two different power regions:
i) a low-power region, wherein only the main amplifier (MAIN) is active, while the auxiliary amplifier (AUX) is off; and
ii) a high-power region, wherein both the main amplifier (MAIN) and the auxiliary amplifier (AUX) are active.

A problem with Doherty amplifiers lies in a power gain penalty (*αM*: for a splitting factor ≤ 0.5) which may be undesirably high.

Documents such as US 2014/132343 A1 (to be further discussed in the following), US 2019/140600 A1, US 2003/201833 A1, US 2024291437 A1, and US2022/158591 A1 are exemplary of related art.

### Object and summary

An object of solutions as described herein is to contribute in effectively addressing that issue.

According to one or more solutions as described herein, such an object can be achieved via Doherty amplifier architecture having the features set forth in the claims that follow.

Solutions as described herein can also relate to a corresponding method.

The claims are an integral part of the technical teaching provided herein in respect of the embodiments.

Solutions as described herein adopt active splitters in order to increase the power gain of a Doherty power amplifier (DPA) while simultaneously increasing efficiency.

An active splitter delivers most of the signal power to the main path, thus improving the DPA power gain (***αM*** ≈ 1), and includes a splitter amplifier that provides the required power to the auxiliary amplifier for proper DPA operation, despite the low splitting factor.

The splitter amplifier is biased to be turned-on at a back-off point. This facilitates minimizing DPA current consumption over all its operating regions, thus improving efficiency.

An active power splitter as described herein consists of a passive splitter and an amplifier (splitter amplifier).

For instance, such a passive splitter can be implemented by exploiting a Wilkinson topology, including a common-source transistor with input and output matching networks used as a splitter amplifier.

In a low-power region, the main amplifier is ON, the auxiliary amplifier is OFF and the splitter amplifier is likewise OFF.

In a high-power region, the main amplifier is ON, the auxiliary amplifier is ON and the splitter amplifier likewise ON.

Solutions as described herein facilitate dispensing with gain limitations, with pre-amplifier size suited to be (at least) halved in comparison with conventional solutions.

A layout of solutions as described herein can be based on a N-way splitter consisting of the cascade of N-1 active splitters each configured to deliver most of its input power to a "preferred" path and capable of driving the auxiliary path.

Each amplifier embedded in the N-way active splitter can be biased to be turned-on at a respective back-off point thus minimizing the DPA current consumption over all its operating regions and hence further improving efficiency.

This again translates into a smaller pre-amplifier in comparison with conventional DPAs, thus further enhancing efficiency.

The last active splitters in such an arrangement can be replaced by a single multi-output passive splitter that is driven by an active splitter with a "wider" splitter amplifier. This approach facilitates achieving an advantageous trade-off between system complexity and efficiency.

Solutions as described herein increase the power gain of a Doherty power amplifier while simultaneously increasing efficiency, via solutions designed to increase (maximize) the power delivered to the main path of the DPA.

### Brief description of the annexed figures

One or more embodiments will now be described, by way of example only, with reference to the annexed figures, wherein:
Figure 1 is a block diagram of the basic layout of a Doherty amplifier;
Figures 2A and 2B are exemplary of operation of a Doherty amplifier in a low-power region and a high-power region, respectively;
Figure 3 is a block diagram showing the basic layout of a Doherty amplifier underlying solutions as proposed herein;
Figures 4A and 4B are exemplary of operation of the basic layout of a Doherty amplifier as illustrated in Figure 3 in a low-power region and a high-power region, respectively;
Figure 5 is a circuit diagram of a possible implementation of an active power splitter suited to be used in solutions as proposed herein;
Figure 6 is illustrative of a general concept that underlies solutions as described herein;
Figure 7 is illustrative of an implementation wherein plural active splitters as illustrated in Figure 6 are replaced by a single passive splitter;
Figure 8 is illustrative of 3-way Doherty amplifier architecture based on the concept illustrated in Figure 6; and
Figure 9 is illustrative of 3-way Doherty amplifier architecture based on the concept illustrated in Figure 7, namely architecture wherein an active splitter as illustrated in Figure 8 is replaced by a passive splitter.

The figures are drawn to clearly illustrate relevant aspects of the solutions described herein and are not necessarily drawn to scale.

The edges of features drawn in the figures do not necessarily indicate the termination of the extent of the feature.

### Detailed description of exemplary embodiments

In the ensuing description, one or more specific details are illustrated, aimed at providing an in-depth understanding of examples of embodiments of this description. The embodiments may be obtained without one or more of the specific details, or with other methods, components, materials, etc. In other cases, known structures, materials, or operations are not illustrated or described in detail so that certain aspects of embodiments will not be obscured.

Reference to "an embodiment" or "one embodiment" in the framework of the present description is intended to indicate that a particular configuration, structure, or characteristic described in relation to the embodiment is comprised in at least one embodiment. Hence, phrases such as "in an embodiment" or "in one embodiment" that may be present in one or more points of the present description do not necessarily refer to one and the same embodiment.

Moreover, particular configurations, structures, or characteristics may be combined in any adequate way in one or more embodiments.

The headings/references used herein are provided merely for convenience and hence do not define the extent of protection or the scope of the embodiments.

Unless the context indicates otherwise, like parts or elements are indicated throughout the figures annexed herein with like references/numerals and a corresponding description will not be repeated for the sake of brevity.

For the sake of simplicity and ease of explanation, a same designation may be applied throughout this description to designate:
a node or line as well as a signal occurring at that node or line;
a component (such as a capacitor, resistor or inductor or coil) as well as electrical parameters (capacitance, resistance, inductance) thereof.

Also, when it is mentioned that an element is "connected to" or "coupled to" another element, it should be understood that an element may be coupled directly to another element or that still another element may be interposed therebetween.

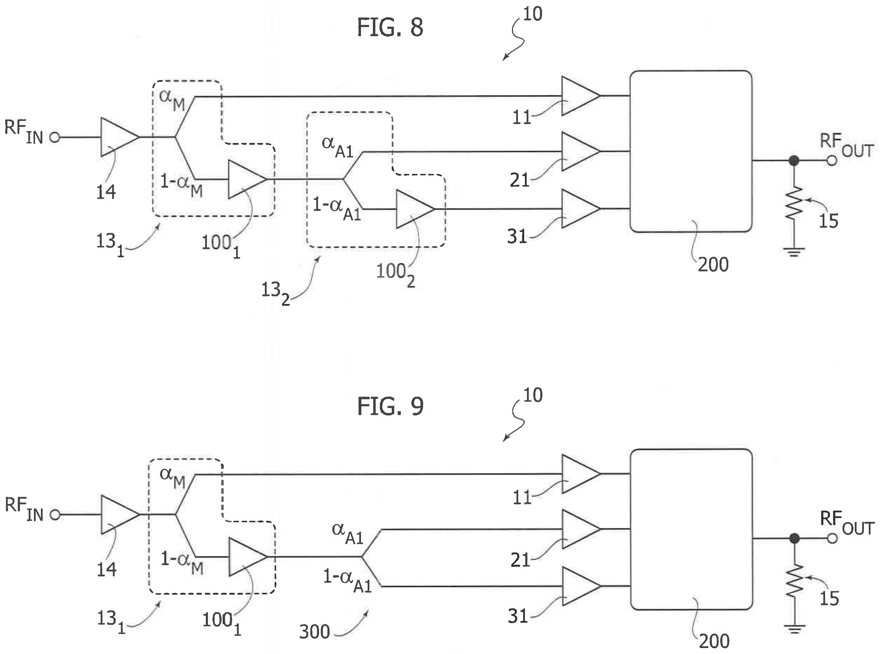

This may be, by way of example, the case of the splitter network referenced as 13₂ in Figure 8 (to be discussed in the following), which is coupled to the amplifier referenced as 31 with the splitter amplifier referenced as 100₂ interposed therebetween.

On the contrary, when it is possibly mentioned that an element is "connected directly to" or "coupled directly to" another element, it should be understood that still another element is not interposed therebetween. This may be, again by way of example, the case of the splitter network referenced as 300 in Figure 9 (to be discussed in the following), which is coupled to the amplifier referenced as 31 directly, with no other element interposed therebetween.

In the diagrams discussed herein certain elements such as matching networks between various amplification stages and/or phase compensation networks involved in providing combined output power in a Doherty amplifier are not visible for simplicity in order to avoid making this description unduly cumbersome.

The 5G network (to which reference will be made throughout as a possible field of application of solutions as described herein) is a key technology for the deployment of next-generation communication systems.

A 5G network envisages:
data rates of up to 100 Gbps;
ultra-low latency (i.e., lower than 1 ms);
high reliability;
massive network capacity, (i.e., a simultaneous connection density higher than 1 M/km2).

To support the stringent requirements of such applications, the 5G network relies on highly spectral efficient modulation schemes, such as 64-QAM with orthogonal frequency division multiplexing (OFDM) modulation scheme.

These modulation schemes offer advantages in terms of high spectral efficiency and high robustness to propagation distortion but otherwise dictate stringent specifications in terms of RF front-end linearity and noise immunity.

High linearity plays a significant role in preserving signal integrity.

The transmitted signals have a high peak-to-average power ratio (PAPR), which leads power amplifiers (PAs) to operate in a deeper output power back-off (OPBO) region.

Power amplifiers typically provide a peak PAE (power added efficiency, namely the ratio of the difference of the output and input signal power to the DC power consumed) at a saturated output power, and PAE rapidly drops at lower output power level.

Simultaneously providing high linearity and high efficiency is a (very) challenging task for a power amplifier.

The Doherty power amplifier (DPA, as proposed in W. Doherty: "A New High Efficiency Power Amplifier for Modulated Waves", Proceedings of the Institute of Radio Engineers, t. 24, no. 9, p. 1163-1182, 1936) is an ideal candidate for the implementation of 5G PAs, in so far as it provides an excellent trade-off between efficiency and linearity thanks to the load modulation.

It is otherwise noted that, while reference will be made throughout to 5G as a possible field of application, solutions as described herein can be advantageously applied to a wide variety of applications, primarily applications where simultaneously achieving high linearity and high efficiency is a goal to be pursued.

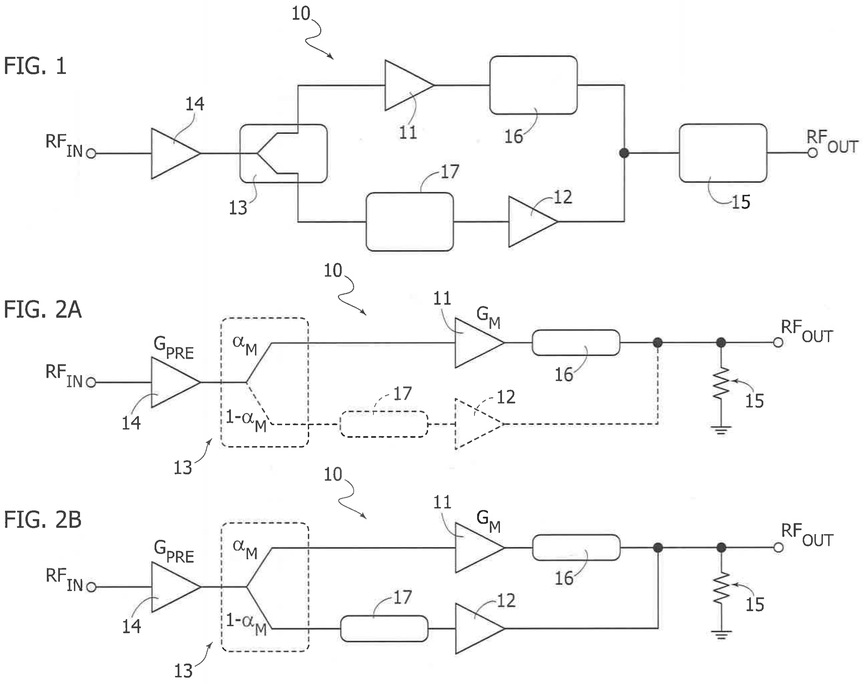

As illustrated in Figure 1, the basic layout of conventional Doherty power amplifier 10 consists of a main (power) amplifier 11 and an auxiliary (power) amplifier 12 that are fed by a power splitter 13 driven by a pre-amplifier 14.

A Doherty amplifier 10 as illustrated in Figure 1 receives a radio-frequency (RF) input signal RF_{IN} at an input node of the preamplifier 14 and includes a matching network 15 that delivers a radio-frequency (RF) output signal RF_{OUT} at an output node of the matching network 15. The matching network 15 is configured to transform the output load into an optimum impedance for the amplifier, namely the impedance that maximizes the power-added efficiency (PAE, which is a metric for rating the efficiency of a power amplifier that takes into account the effect of the gain of the amplifier) and/or the output power.

To that effect, the matching network 15 is coupled to the output of the main power amplifier 11 via an impedance inverter 16 and with the output of the auxiliary (power) amplifier 12 that is coupled to the power splitter 13 via a phase compensator 17.

The main amplifier operates in class AB and the auxiliary amplifier operates in class B/C, with two operating regions (low and high output power) of the Doherty amplifier 10 identified by the auxiliary amplifier turn-on and the main amplifier operating at its peak efficiency in the high-power region.

As discussed so far, the basic structure and operation of a Doherty power amplifier or DPA (including activation of the auxiliary amplifier 12 at a respective back-off point) is well known in the art and a further detailed description is not provided herein for brevity.

The Doherty power amplifier suffers from an inherent power gain penalty due to the unbalanced operating scheme (different classes of operation for the main and auxiliary amplifiers).

This is exemplified in Figures 2A and 2B.

These figures refer to low-power operation (main amplifier 11 on and auxiliary amplifier 12 off - Figure 2A) and high-power operation (main amplifier 11 on and auxiliary amplifier 12 on - Figure 2B) with inactive elements represented in dashed lines.

The following relationship applies to the case exemplified in Figures 2A and 2B: ${G}_{T} = {G}_{PRE} {α}_{M} {G}_{M} \leq {G}_{PRE} {G}_{M} / 2$ where:
*G_{T}*: total power gain
*G_{PRE}:* pre-amplifier power gain
*G_{M}*: main power gain; and
*α_{M}*: splitting factor
Assuming *α*_{M} ≤ 0.5, this amounts to a gain penalty ≥ 3dB.

The Doherty power amplifier is the subject-matter of quite extensive technical literature.

For instance, two-way asymmetric DPAs can implement an efficiency peak at a deeper back-off by using a wider peaking amplifier. However, this results in an efficiency dip between the two peaks, which compromises the average efficiency when amplifying modulated signals.

More to the point, correct operation of an asymmetric DPA (with the auxiliary amplifier larger than the main amplifier) involves a factor *αM* that decreases with the depth of the back-off target. This entails an increase in the portion of power split towards the auxiliary amplifier, which ultimately translates into an increase in the penalty in terms of DPA gain, and also requires a larger preamplifier, which further penalizes performance in terms of DPA efficiency.

Efficiency enhancement up to the deeper back-off can be achieved by increasing the number of auxiliary amplifiers (N-way DPA) with a M-th auxiliary amplifier with deeper class C operation than the (M-1)-th one (that is, with lower bias voltage).

The gain penalty is however exacerbated due to higher splitting ratio between the auxiliary amplifiers and the main amplifier: most of the input power is delivered to the auxiliary amplifiers.

A. Piacibello, et al. in: "34 dBm GaN Doherty Power Amplifier for Ka-band satellite downlink" 2020 15th European Microwave Integrated Circuits Conference (EuMIC), Utrecht, Netherlands, 2021, pp. 25-28 propose an input splitter designed to provide uneven power splitting, with an auxiliary/main input power ratio of 1.25 (i.e., *α_{M}=* 0.44). This is a trade-off between full turn-on of the peaking power device, which is essential to ensure the desired 6-dB output power back-off (OPBO), with a resulting gain penalty (i.e.,-10log (*α_{M} ) =* 3.6dB).

T. Kitahara, et al. in: "Asymmetrical Doherty amplifier using GaN HEMTs for high-power applications", 2012 IEEE Topical Conference on Power Amplifiers for Wireless and Radio Applications, Santa Clara, USA, 2012, pp. 57-60 propose a 2-way asymmetrical DPA (auxiliary amplifier size greater than the main one) to achieve a deeper OPBO (i.e., OPBO > 6 dB) but at the cost of both a lower average efficiency and an increase in gain penalty (i.e., *α_{M}=* 0.33 which translates into a gain penalty -10log (*α_{M}* ) = 4.8dB).

A. Piacibello, et al. in: "3-Way Doherty Power Amplifiers: Design Guidelines and MMIC Implementation at 28 GHz", IEEE Trans. Microw. Theory Tech., vol. 71, no. 5, pp. 2016-2028, May 2023 propose 3-way DPAs to improve efficiency performance at deeper OPBO (i.e., OPBO > 6 dB) while simultaneously preserving the average efficiency at the cost of higher penalty gain (i.e., *α_{M} =* 0.1 which translates into a gain penalty -10log (*α_{M}* ) = 10dB).

An extensive review of the activity devoted to Doherty power amplifiers is provided in the dissertation submitted with the UNIVERSITE' DE BORDEAUX (Bordeaux University) by Gwennaël DIVERREZ: "Conception d'un amplificateur de puissance Doherty large bande à base de coupleurs hybrides sur charge inductive aux fréquences 5G millimétriques en technologie CMOS 28nm FD-SOI" (in French, available at the URL theses.hal.science/tel-04197015v1/file/DIVERREZ_GWENNAEL_2023.pdf).

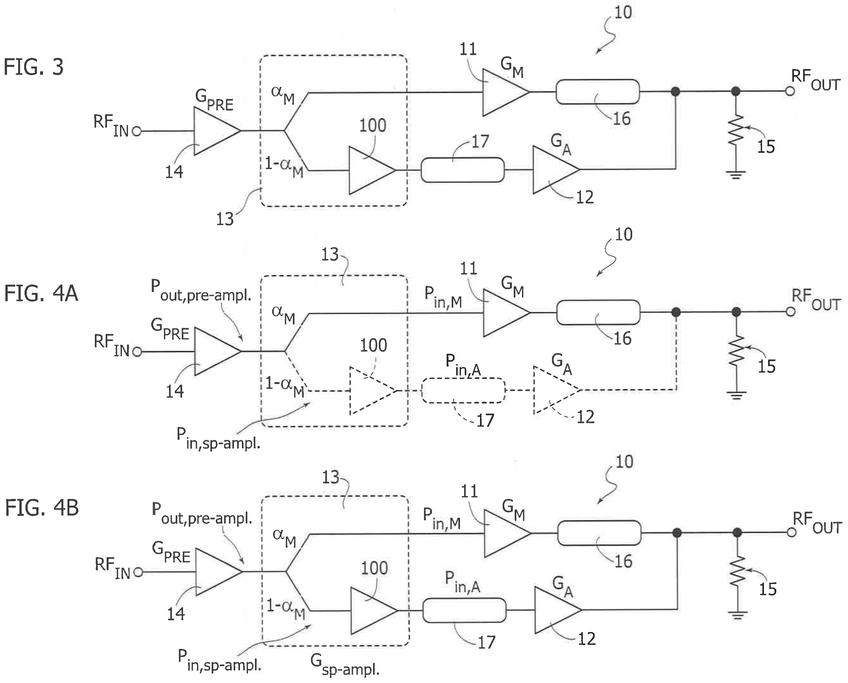

Figure 3 is a block diagram of the layout of a Doherty amplifier that underlies solutions as proposed herein.

In Figure 3, parts or elements like parts or elements already presented in connection with Figure 1, Figure 2A, and Figure 2B are indicated throughout with like references/numerals and a corresponding description will not be repeated for the sake of brevity.

The solution illustrated in Figure 3 adopts a splitter 13 that is "active" insofar as it includes a splitter amplifier 100 associated with the signal propagation path from the preamplifier 14 towards the auxiliary amplifier 12.

In that way, power gain can be increased (maximized) while simultaneously increasing efficiency.

The active splitter 13 illustrated in Figure 3 can be configured to deliver most of the signal power from the preamplifier 14 (***α_{M}*** ≈ 1) to the "main" path towards the main amplifier 11, thus improving the DPA power gain.

The active splitter 13 is likewise configured to provide adequate power to the auxiliary amplifier 12 for proper DPA operation, despite the low splitting factor (i.e., 1-***α_{M}***), so that the following relationship applies to the case exemplified in Figures 4A (low-power region) and 4B (high-power region): ${G}_{T} \approx {G}_{PRE} {G}_{M}$ where again:
*G_{T}*: total power gain
*G_{PRE}:* pre-amplifier power gain
*G_{M}*: main power gain; and
*α_{M}*: splitting factor.

Figures 4A and 4B again refer to low-power operation (main amplifier 11 on and auxiliary amplifier 12 plus splitter amplifier 100 off - Figure 4A) and high-power operation (main amplifier 11 on and auxiliary amplifier 12 plus splitter amplifier 100 on - Figure 4B) with inactive elements represented in dashed lines.

The power *P_{in,M}* input to the main amplifier 11 (having a gain *G_{M}*) is thus essentially equal the power of the signal is *P_{out,pre-ampl}* from the preamplifier 14.

The power *P_{in,A}* input to the auxiliary amplifier 12 is given by the power *P_{out,pre-ampl}* output to the preamplifier 14, times the (very) low splitting factor (i.e., 1-***α_{M}***) and the gain *Gₛₚ₋ₐₘₚₗ* of the splitter amplifier 100.

Thanks to the active splitter, no gain limitation arises.

The splitter amplifier 100 can be adequately biased to be turned-on at a back-off point this allows minimizing the DPA current consumption all over its operating regions, thus improving efficiency; in solutions as proposed herein the size of the pre-amplifier 14 can be (at least) halved in comparison with conventional solutions. This facilitates further improvements in performance efficiency across all operating regions of the DPA.

A solution essentially akin to the basic layout illustrated in Figure 3 is disclosed in US 2014/132343 A1, where a Nonlinear Driver Amplifier, NDA, is arranged in the auxiliary amplifier branch in order to increase the gain in the auxiliary amplifier branch.

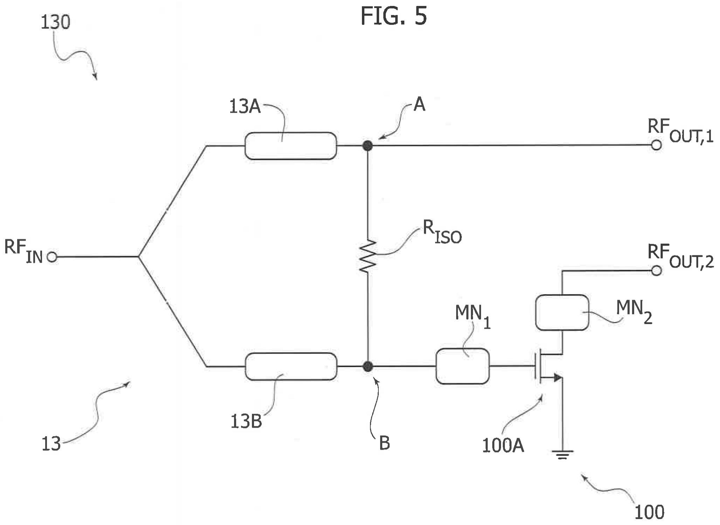

Figure 5 is a circuit diagram of a possible implementation of an active power splitter 130 in solutions as discussed herein.

As illustrated in Figure 5, such an active power splitter 130 may include a (passive) power splitter network 13 in combination with a splitter amplifier 100.

Advantageously, the power splitter network 130 can be based on a so-called Wilkinson topology as proposed in E.J. Wilkinson: "An N-way Power Divider", IRE Trans. on Microwave Theory and Techniques, vol. 8, p. 116-118, Jan. 1960.

Such a splitter network can be regarded as configured to split unevenly an input RF signal (from the preamplifier 14 if one refers to the Doherty amplifier layouts discussed previously) over a first branch 13A (of an impedance TL1, Z_{0,1}) towards a node A coupled to the main amplifier 11 and a second branch 13B (of an impedance TL2, Z_{0,2}) towards a node B coupled to the auxiliary amplifier 12 through the splitter amplifier 100. As illustrated in Figure 5, an isolation resistor R_{ISO} is coupled between the nodes A and B.

The arms or branches 13A and 13B have un-equal impedances, so that asymmetric division of the input power over the two nodes A and B can be achieved.

As illustrated in Figure 5, the splitter amplifier 100 may include a common source transistor 100A (in an exemplary implementation, this may be based on field-effect transistor such as a MOSFET transistor) with input and output matching networks MN₁ and MN₂ coupled:
between the node B and the control terminal (gate, in an exemplary implementation based on field-effect transistor such as a MOSFET transistor), and
between the current flow path (at the drain, in an exemplary implementation based on field-effect transistor such as a MOSFET transistor) through the transistor 100A and the auxiliary amplifier 12 (via the phase compensator 17).

In a circuit as illustrated in Figure 5, a first output signal RFₒᵤₜ₁ is available at the node A and a second output signal RFₒᵤₜ₂ is available at the terminal of the matching network MN₂ opposite the terminal coupled to the transistor 100A.

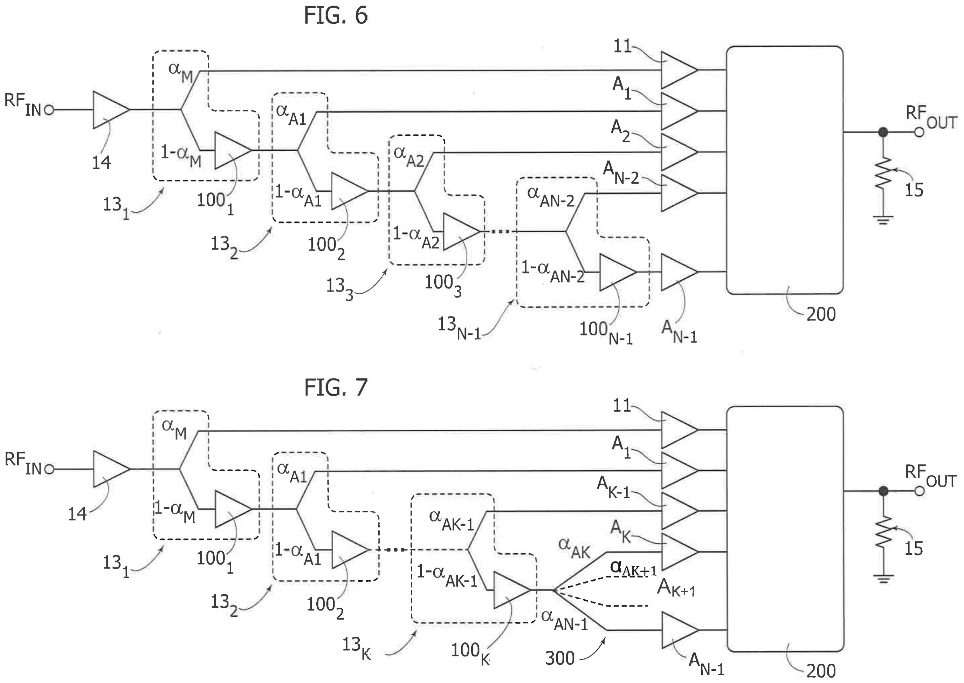

Figure 6 is exemplary of the possibility of extending the Doherty circuit layout discussed in the foregoing using a N-way active splitter including the cascade of N-1 active splitters each including a passive splitter circuit 13₁, 13₂, 13₃, ..., 13_{N-1} and an associated splitter amplifier 100₁, 100₂, 100₃, ..., 100_{N-1} designed to deliver:
most of its input power, namely a major portion of its input power via a nearly unitary splitting factor *α_{M}*; *α*_{A1}; *α*_{A2}; ...; *α*_{AN-2}, to a "main" path direct to a respective (output stage) amplifier 11, A₁, A₂, ..., A_{N-2};
a minor portion of its input power, via a nearly zero splitting factor 1-*α_{M}*; 1-*α*_{A1}; 1-*α*_{A2}; ...; 1-*α*_{AN-2}, to an auxiliary path towards a respective splitter amplifier 100₁, 100₂, 100₃, ..., 100_{N-1} in an active splitter cascaded thereto or, in the case of the last active splitter (rightmost in Figure 6) in the cascaded arrangement, direct to a respective (output stage) amplifier A_{N-1}.

The outputs from the amplifiers 11, A₁, A₂, ..., A_{N-2} and A_{N-1} are then combined in an N-way output combiner 200.

The amplifiers A₁, A₂, ..., A_{N-2} and A_{N-1}, namely all of the auxiliary (secondary) amplifiers upstream of the combiner 200 (thus, with the exception of the "main" amplifier 11) plus the splitter amplifiers 100₁, 100₂, 100₃, ..., 100_{N-1} embedded in the N-way active splitter can be configured to be biased and to be turned-on at a related back-off point thus minimizing the DPA current consumption all over its operating regions and hence improving efficiency.

The pre-amplifier is smaller than the preamplifier in a conventional DPA thus further enhancing the efficiency performance.

Figure 7 (where parts or elements like parts or elements already introduced in connection with earlier figures are indicated with like reference symbols so that a detailed description is not repeated for brevity) is exemplary of an implementation wherein the last (N-k-1) active splitters in Figure 6 are replaced by a single multi-output passive splitter 300 with (N-k) outputs driven by a "wider" splitter amplifier 100_{K} in a k-th active splitter 13_{K}, 100_{K}.

This approach facilitates an adequate best trade-off between system complexity and efficiency performance to be achieved.

The circuits exemplified in Figure 8 and in Figure 9 are simplified 3-way implementations of the circuits exemplified in Figure 6 and in Figure 7.

The circuits exemplified in Figure 8 and in Figure 9 thus comprises a single secondary signal splitter, namely 13₂, 100₂ in Figure 8 and 300 in Figure 9 configured to receive a respective input signal from the first splitter amplifier 100₁ of the first signal splitter 13₁, 100₁.

To summarize, circuits as proposed herein can be regarded as exemplary of a circuit essentially based on Doherty amplifier architecture and comprising a first signal splitter 13₁, 100₁ coupled to an input node (via the preamplifier 14) and configured to receive an input signal RF_{IN}.

As illustrated, the first signal splitter 13₁, 100₁ comprises a passive splitter network 13₁ and a splitter amplifier 100₁. The passive splitter network 13₁ is configured to forward a first portion αM (nearly all) of the input signal RF_{IN} over a first splitter branch towards a first amplifier 11 and a second portion 1-α_{M} (a small fraction) of the input signal RF_{IN} over a second splitter branch towards the associated splitter amplifier 100₁.

Circuits as proposed herein include one or more secondary signal splitters 13₂, 100₂, 13₃, 100₃, ..., 13_{N-1}, 100_{N-1} (see Figure 6); 13₂, 100₂, ..., 13ₖ, 100ₖ, 300 (see Figure 7); 13₂, 100₂ (see Figure 8); and 300 (see Figure 9).

The or each such secondary signal splitter is configured to receive a respective input signal coming from the first splitter amplifier 100₁ in the first signal splitter 13₁, 100₁ and comprises a passive secondary splitter network 13₂, 13₃, ..., 13_{N-1}; 13₂, ..., 13ₖ, 300; 13₂; 300 configured to forward:
a first portion α_{A1}, α_{A2}, ..., α_{AN-2}; α_{A1}, ..., α_{AK-1}, α_{AK}; α_{A1}; α_{A1} of the respective input signal received towards a respective secondary amplifier A₁, A₂, ...,A_{N-2}; A₁, ...,A_{K-1}, A_{K}; 21 and
a second portion 1-α_{A1}, 1-α_{A2}, ..., 1- α_{AN-2}; 1-α_{A1}, ..., 1-α_{AK-1}, ..., α_{AN-1}; 1-α_{A1} of the respective input signal towards a respective further secondary amplifier A_{N-}1; A_{K+1}, ..., A_{N-1}; 31.

The circuits as illustrated include a combiner 200 coupled to the first amplifier 11, the or each secondary amplifier A₁, A₂, ...,A_{N-2}; A₁,...,A_{K-1}, A_{K}; 21 and the respective further secondary amplifier A_{N-1}; A_{K+1},..., A_{N-1}; 31 thus being able to provide at the output node RF_{OUT} an output signal resulting from the output signal from the first amplifier (11) in possible combination with an output signal from the secondary amplifier(s) A₁, A₂, ...,A_{N-2}; A₁,...,A_{K-1}, A_{K}; 21, and an output signal from the respective further secondary amplifier A_{N-1}; A_{K+1},..., A_{N-1}; 31.

The circuits exemplified in Figures 6 and 7 comprise a plurality of secondary signal splitters (these are referenced as 13₂, 100₂; 13₃, 100₃; ...; 13_{N-1}, 100_{N-1} in Figure 6 and as 13₂, 100₂; ...; 13_{K}, 100_{K}; 300 in Figure 7) in a cascaded arrangement.

As illustrated, each secondary signal splitter in the cascaded arrangement is configured to receive a respective input signal coming:
from the first splitter amplifier 100₁ of the first signal splitter 13₁, 100₁, or
from a secondary signal splitter arranged upstream in said cascaded arrangement.

As illustrated, each secondary signal splitter in the cascaded arrangement comprises a passive secondary splitter network (see 13₂, 13₃, ...; 13_{N-1} in Figure 6 or 13₂, ..., 13_{K}, 300 in Figure 7) that is configured to forward a first portion α_{A1}, α_{A2}, ..., α_{AN-2} (Figure 6) or α_{A1}, ..., α_{AK-1}, α_{AK} (Figure 7) of the respective input signal towards a respective one of a plurality of secondary amplifiers (see A₁, A₂, ...,A_{N-2} in Figure 6 and A₁,...,A_{K-1}, A_{K} in Figure 7) and a second portion 1-α_{A1}, 1-α_{A2}, ..., 1- α_{AN-2} (Figure 6) or 1-α_{A1}, ..., 1-α_{AK-1}, α_{AK+1},..., α_{AN-1} (Figure 7) of the respective input signal towards the respective further secondary amplifier A_{N-1}, A_{K+1},..., A_{N-1}:
via a secondary signal splitter arranged downstream in the cascaded arrangement, or
directly.

In the circuits exemplified in Figures 6 and 7, the combiner circuitry 200 is coupled to the output of the first amplifier 11, the outputs of the plurality of secondary amplifiers (A₁, A₂, ...,A_{N-2} in Figure 6 or A₁,...,A_{K-1}, A_{K} in Figure 7), and the output of the further secondary amplifier(s), namely A_{N-1}(in Figure 6) and A_{K+1},..., A_{N-1} (in Figure 7).

In the circuit exemplified in Figure 6, the passive splitter network 13₂, 13₃, ..., 13_{N-1} in each secondary signal splitter has a splitter amplifier 100₂, 100₃, ..., 100_{N-1} coupled therewith and the passive splitter network 13₂, 13₃, ...; 13_{N-1} in each such secondary signal splitter is configured to forward:
a first portion α_{A1}, α_{A2}, ... , α_{AN-2} of the respective input signal towards a respective secondary amplifier A₁, A₂, ..., A_{N-2}, and
a second portion 1-α_{A1}, 1-α_{A2}, ..., 1-α_{AN-2} of the respective input signal towards the splitter amplifier 100₂, 100₃, ..., 100_{N-1} coupled therewith.

In the circuit exemplified in Figure 6, the further secondary amplifier A_{N-1} is coupled to the splitter amplifier 100_{N-1} of the last secondary signal splitter 13_{N-1}, 100_{N-1}.

The circuit exemplified in Figure 7 comprises a set of secondary signal splitters (referenced as 13₂, 100₂; ...; 13_{K}, 100_{K}) and the passive splitter network (namely 13₂; ...; 13_{K}) in each secondary signal splitter in that set:
has a splitter amplifier (namely 100₂, ..., 100ₖ) coupled therewith, and
is configured to forward the aforesaid second portion 1-α_{A1}, ..., 1-α_{AK-1} of the respective input signal towards the splitter amplifier 100₂, ..., 100ₖ coupled therewith.

The circuit exemplified in Figure 7 also comprises a multi-output passive splitter 300 (having N-K outputs), configured to forward respective portions α_{AK},...,α_{AN-1} of the respective input signal towards respective secondary amplifiers A_{K},..., A_{N-1}.

As discussed, the circuits exemplified in Figure 8 and in Figure 9 are simplified 3-way implementations of the circuits exemplified in Figure 6 and in Figure 7.

The circuits exemplified in Figure 8 and in Figure 9 thus comprises a single secondary signal splitter, namely 13₂, 100₂ in Figure 8 and 300 in Figure 9 configured to receive a respective input signal from the first splitter amplifier 100₁ of the first signal splitter 13₁, 100₁.

In the circuits exemplified in Figure 8 and in Figure 9 the single secondary signal splitter 13₂, 100₂ or 300 comprises a passive secondary splitter network (namely 13₂ or 300) that is configured to forward:
a first portion α_{A1} of the respective input signal towards the secondary amplifier 21, and
a second portion 1-α_{A1} of the respective input signal towards the respective further secondary amplifier 31.

In the circuits exemplified in Figure 8 and in Figure 9 the combiner circuitry 200 is coupled to the output of the first amplifier 11, the output of the secondary amplifier 21, and the output of the further secondary amplifier 31.

In the case of the circuit exemplified in Figure 8, the passive splitter network 13₂ in the single secondary signal splitter 13₂, 100₂ has a secondary splitter amplifier 100₂ coupled therewith, and the passive splitter network 13₂ in the secondary signal splitter 13₂, 100₂ is configured to forward:
a first portion α_{A1} of the respective input signal towards the secondary amplifier 21, and
a second portion 1-α_{A1} of the respective input signal towards the splitter amplifier 100₂ coupled therewith.

In the case of the circuit exemplified in Figure 8, the (further) secondary amplifier 31 is coupled to the splitter amplifier 100₂ of the secondary signal splitter 13₂, 100₂.

In the case of the circuit exemplified in Figure 9, the (single) secondary signal splitter comprises (only) the multi-output passive splitter network 300, that is configured to forward:
a first portion α_{A1} of the respective input signal towards the secondary amplifier 21, and
a second portion 1-α_{A1} of the respective input signal towards the (further) secondary amplifier 31.

In the case of the circuit exemplified in Figure 9, the secondary amplifier 31 is thus coupled directly to the passive splitter network 300 in the single secondary signal splitter.

Advantageously, the first portion α_{M} of the input signal RF_{IN} and the second portion 1-α_{M} of the input signal RF_{IN} referred to in the foregoing are a majority portion (a large majority, for example) and a minority portion (a small minority, for example), respectively, of the input signal RF_{IN}.

Likewise advantageously, the first portion α_{A1}, α_{A2}, ..., α_{AN-2}; α_{A1}, ..., α_{AK-1}, α_{AK}; α_{A1} of the respective input signal and the second portion 1-α_{A1}, 1-α_{A2}, ..., 1- α_{AN-2}; 1-α_{A1}, ..., 1-α_{AK-1}, α_{AN-1}; 1-α_{A1} of the respective input signal are a majority portion (a large majority, for example) and a minority portion (a small minority, for example), respectively, of the respective input signal.

The gain of the splitter amplifiers associated with those signal paths that, as a result of power splitting, receive minor amounts of power can provide adequate compensation and restore useful signal intensity.

Exemplary values of factors such as α and 1-α (suffixes are not reproduced for brevity) may be, by way of non-limiting example, 0.9 and 0.1, respectively.

Operation of the circuits proposed herein again refers to the Doherty amplifier, with a radio-frequency (RF) input signal RF_{IN} applied to the input node, here represented by the preamplifier 14 having the first signal splitter 13₁, 100₁ coupled thereto and the circuit operated (in a manner known per se to those of skill in the art) in a first, low-power operating mode (see Figures 2A and 4A, by way of comparative reference), and at least one second, high-power operating mode (see Figures 2B and 4B, again by way of comparative reference).

In the first operating mode, (only) the first amplifier 11 is active and the first splitter amplifier 100₁ in the first signal splitter 13₁, 100₁ is inactive. In that way the secondary signal splitter(s) 13₂, 100₂, 13₃, 100₃, ..., 13_{N-1}, 100_{N-1} (Figure 6); 13₂, 100₂, ..., 13ₖ, 100ₖ, 300 (Figure 7); 13₂, 100₂ (Figure 8); and 300 (Figure 9) do not receive the respective input signal coming (directly or indirectly) from the first splitter amplifier 100₁ in the first signal splitter 13₁, 100₁.

In the second operating mode(s), both the first amplifier 11 and the first splitter amplifier 100₁ in the first signal splitter 13₁, 100₁ are active and the respective secondary amplifier A₁, A₂, ...,A_{N-2}; A₁, ...,A_{K-1}, A_{K}; 21 and the respective further secondary amplifier A_{N-1}; A_{K+1}, ..., A_{N-1}; 31 are activated at respective back-off points.

In those solutions (Figure 6, Figure 7 and Figure 8) wherein at least one secondary signal splitter is provided including a passive splitter network plus a splitter amplifier (see 100₂, 100₃, ...,100_{N-1}; 100₂) coupled therewith, the second operating mode(s) involve activating such splitter amplifier in response to the secondary amplifier(s) A₁, A₂, ...,A_{N-2}; A₁,...,A_{K-1}, A_{K}; 21 and the further secondary amplifier A_{N-1}; A_{K+1},..., A_{N-1}; 31 being activated at a respective back-off point.

Performance (simulated) of a circuit implemented in a 150-nm GaN-on-SiC technology as proposed in Figure 9 was compared with performance of a conventional 3-way DPA as discussed in the paper by A. Piacibello, et al.: "3-Way Doherty Power Amplifiers: Design Guidelines and MMIC Implementation at 28 GHz", IEEE Trans. Microw. Theory Tech., vol. 71, no. 5, pp. 2016-2028, May 2023 (already cited).

The following table reproduces comparison results of specifications for conventional 3-way DPA of the Piacibello reference and the solution proposed in Figure 9.

**Table I - Comparison results**

| Specification | Reference | Proposal - Figure 9 |
|---|---|---|
| Operating frequency [GHz] | 28 | 28 |
| Power gain [dB] | 15 | 23 |
| Psat [dBm] | 34 | 36 |
| PAE@12dBOPBO | 15% | 23% |
| PAE@6dBOPBO | 16% | 28% |
| PAE@sat | 22% | 32% |

In Table I:
Psat = power at saturation
PAE = power added efficiency
OPBO = output power back-off

Without prejudice to the underlying principles, the details and embodiments may vary, even significantly, with respect to what has been described by way of example only without departing from the extent of protection.

The extent of protection is determined by the annexed claims.

## Claims

1. A circuit, comprising:
a first signal splitter (13₁, 100₁) coupled to an input pre-amplifier (14) and configured to receive an input signal (RF_{IN}), the first signal splitter (13₁, 100₁) comprising a first passive splitter network (13₁) and a first splitter amplifier (100₁), wherein the first passive splitter network (13₁) is configured to forward a first portion (α_{M}) of the input signal (RF_{IN}) towards a first amplifier (11) and a second portion (1-α_{M}) of the input signal (RF_{IN}) towards the first splitter amplifier (100₁);
at least one secondary signal splitter (13₂, 100₂, 13₃, 100₃, ..., 13_{N-1}, 100_{N-1}; 13₂, 100₂, ..., 13ₖ, 100ₖ, 300; 13₂, 100₂; 300), wherein the at least one secondary signal splitter (13₂, 100₂, 13₃, 100₃, ..., 13_{N-1}, 100_{N-1}; 13₂, 100₂, ..., 13ₖ, 100ₖ, 300; 13₂, 100₂; 300) is configured to receive a respective input signal coming from said first splitter amplifier (100₁) in the first signal splitter (13₁, 100₁) and comprises a passive secondary splitter network (13₂, 13₃,..., 13_{N-1}; 13₂, ..., 13ₖ, 300; 13₂; 300) configured to forward a first portion (α_{A1}, α_{A2}, ..., α_{AN-2}; α_{A1}, ..., α_{AK-1}, α_{AK}; α_{A1}) of said respective input signal towards a respective secondary amplifier (A₁, A₂, ...,A_{N-2}; A₁, ...,A_{K-1}, A_{K}; 21) and a second portion (1-α_{A1}, 1-α_{A2}, ..., 1- α_{AN-2}; 1-α_{A1}, ..., 1-α_{AK-1}, α_{AK+1},..., α_{AN-1}; 1-α_{A1}) of said respective input signal towards a respective further secondary amplifier (A_{N-1}; A_{K+1},..., A_{N-1}; 31) and
combiner circuitry (200) coupled to said first amplifier (11), said respective secondary amplifier (A₁, A₂, ...,A_{N-2}; A₁,...,A_{K-1}, A_{K}; 21) and said respective further secondary amplifier (A_{N-1}; A_{K+1},..., A_{N-1}; 31), wherein the combiner circuitry (200) is configured to provide at an output node (RF_{OUT}) an output signal resulting from a combination of an output signal from said first amplifier (11), an output signal from said respective secondary amplifier (A₁, A₂, ...,A_{N-2}; A₁,...,A_{K-1}, A_{K}; 21), and an output signal from said respective further secondary amplifier (A_{N-1};A_{K+1},..., A_{N-1}; 31).

2. The circuit of claim 1, comprising a plurality of secondary signal splitters (13₂, 100₂; 13₃, 100₃; ...; 13_{N-1}, 100_{N-1} or 13₂, 100₂; ...; 13_{K}, 100_{K}; 300) in a cascaded arrangement wherein:
each secondary signal splitter in the plurality of secondary signal splitters (13₂, 100₂; 13₃, 100₃; ...; 13_{N-1}, 100_{N-1} or 13₂, 100₂; ...; 13_{K}, 100_{K}; 300) is configured to receive a respective input signal coming from the first splitter amplifier (100₁) of the first signal splitter (13₁, 100₁) either from said first splitter amplifier (100₁) of the first signal splitter (13₁, 100₁) or from a secondary signal splitter in the plurality of secondary signal splitters (13₂, 100₂; 13₃, 100₃; ...; 13_{N-1}, 100_{N-1} or 13₂, 100₂; ...; 13_{K}, 100_{K}) arranged upstream in said cascaded arrangement;
each secondary signal splitter in the plurality of secondary signal splitters (13₂, 100₂; 13₃, 100₃; ...; 13_{N-1}, 100_{N-1} or 13₂, 100₂; ...; 13_{K}, 100_{K}; 300) comprises a passive secondary splitter network (13₂, 13₃, ...; 13_{N-1}; 13₂, ..., 13_{K}, 300) configured to forward a first portion (α_{A1}, α_{A2}, ..., α_{AN-2}; α_{A1}, ..., α_{AK-1}, α_{AK}) of said respective input signal towards a respective one of a plurality of secondary amplifiers (A₁, A₂, ...,A_{N-2}; A₁,...,A_{K-1}, A_{K}) and a second portion (1-α_{A1}, 1-α_{A2}, ..., 1- α_{AN-2}; 1-α_{A1}, ..., 1-α_{AK-1}, α_{AK+1},..., α_{AN-1}) of said respective input signal towards said respective further secondary amplifier (A_{N-1}; A_{K+1},..., A_{N-1}) either via a secondary signal splitter in the plurality of secondary signal splitters (13₂, 100₂; 13₃, 100₃; ...; 13_{N-1}, 100_{N-1} or 13₂, 100₂; ...; 13_{K}, 100_{K}) arranged downstream in said cascaded arrangement or directly; and
the combiner circuitry (200) is coupled to the output of the first amplifier (11), the outputs of the secondary amplifiers of said plurality of secondary amplifiers (A₁, A₂, ...,A_{N-2}; A₁, ...,A_{K-1}, A_{K}), and the output of the further secondary amplifier (A_{N-1}, A_{K+1}, ..., A_{N-1}).

3. The circuit of claim 2, wherein:
the passive splitter network (13₂, 13₃, ...; 13_{N-1}) in each secondary signal splitter in the plurality of secondary signal splitters (13₂, 100₂; 13₃, 100₃; ...; 13_{N-1}, 100_{N-1}) has a secondary splitter amplifier (100₂, 100₃, ..., 100_{N-1}) coupled therewith,
the passive splitter network (13₂, 13₃, ...; 13_{N-1}) in each secondary signal splitter in the plurality of secondary signal splitters (13₂, 100₂; 13₃, 100₃; ...; 13_{N-1}, 100_{N-1}) is configured to forward a first portion (α_{A1}, α_{A2}, ... , α_{AN-2}) of said respective input signal towards said respective secondary amplifier (A₁, A₂, ..., A_{N-2}) and a second portion (1-α_{A1}, 1-α_{A2}, ..., 1-α_{AN-2}) of said respective input signal towards said secondary splitter amplifier (100₂, 100₃, ..., 100_{N-1}) coupled therewith; and
said further secondary amplifier (A_{N-1}) is coupled to the secondary splitter amplifier(100_{N-1}) of the last secondary signal splitter (13_{N-1}, 100_{N-1}) in said cascaded arrangement of secondary signal splitters (13₂, 100₂; 13₃, 100₃; ...; 13_{N-1}, 100_{N-1}).

4. The circuit of claim 2, wherein the plurality of secondary signal splitters (13₂, 100₂; ...; 13_{K}, 100_{K}; 300) comprises:
a set of secondary signal splitters (13₂, 100₂; ...; 13_{K}, 100_{K}) wherein the passive splitter network (13₂,; ...; 13_{K}) in each secondary signal splitter in said set of secondary signal splitters (13₂, 100₂; ...; 13_{K}, 100_{K}) has a secondary splitter amplifier (100₂, ..., 100_{K}) coupled therewith and is configured to forward said second portion (1-α_{A1}, ..., 1-α_{AK-1}) of said respective input signal towards the secondary splitter amplifier (100₂, ..., 100_{K}) coupled therewith; and
multi-output secondary signal splitter circuitry (300) configured to forward respective portions (α_{AK}, α_{AK+1}, ..., α_{AN-1}) of said respective input signal towards respective secondary amplifiers A_{K}, A_{K+1}, ..., A_{N-1}.

5. The circuit of claim 1, comprising:
a secondary signal splitter (13₂, 100₂; 300) configured to receive said respective input signal from said first splitter amplifier (100₁) of the first signal splitter (13₁, 100₁), wherein said secondary signal splitter (13₂, 100₂; 300) comprises a passive secondary splitter network (13₂, 300) configured to forward a first portion (α_{A1}) of said respective input signal towards said respective secondary amplifier (21) and a second portion (1-α_{A1}) of said respective input signal towards said respective further secondary amplifier (31); and
the combiner circuitry (200) is coupled to the output of the first amplifier (11), the output of the secondary amplifier (21), and the output of the further secondary amplifier (31).

6. The circuit of claim 5, wherein:
the passive splitter network (13₂) in said secondary signal splitter (13₂, 100₂) has a secondary splitter amplifier (100₂) coupled therewith,
the passive splitter network (13₂) in said secondary signal splitter (13₂, 100₂) is configured to forward a first portion (α_{A1} ) of said respective input signal towards said respective secondary amplifier (21) and a second portion (1-α_{A1}) of said respective input signal towards said secondary splitter amplifier (100₂) coupled therewith; and
said further secondary amplifier (31) is coupled to the secondary splitter amplifier (100₂) of said secondary signal splitter (13₂, 100₂).

7. The circuit of claim 5, wherein said secondary signal splitter (300) comprises a passive splitter network (300) configured to forward a first portion (α_{A1}) of said respective input signal towards said secondary amplifier (21) and a second portion (1-α_{A1}) of said respective input signal towards said respective further secondary amplifier (31) wherein said further secondary amplifier (31) is coupled directly to the passive splitter network (300) in said secondary signal splitter.

8. The circuit of any of the previous claims, wherein:
said first portion (α_{M}) of the input signal (RF_{IN}) and said second portion (1-α_{M}) of the input signal (RF_{IN}) are a majority portion and a minority portion, respectively, of said input signal (RF_{IN}); and
said first portion (α_{A1}, α_{A2}, ..., α_{AN-2}; α_{A1}, ..., α_{AK-1}, α_{AK}; α_{A1}) of said respective input signal and said second portion (1-α_{A1}, 1-α_{A2}, ..., 1- α_{AN-2}; 1-α_{A1}, ..., 1-α_{AK-1}, α_{AK+1},..., α_{AN-1}; 1-α_{A1}) of the said respective input signal are a majority portion and a minority portion, respectively, of said respective input signal.

9. The circuit of any of the previous claims, wherein said passive splitter networks (13₁, 13₂, 13₃, ..., 13_{N-1}; 13₁, 13₂, ..., 13ₖ; 300) are implemented via a Wilkinson topology.

10. A method comprising:
providing a circuit according to any of claims 1 to 9, applying an input signal (RF_{IN}) to said input pre-amplifier (14) having the first signal splitter (13₁, 100₁) coupled thereto, and operating said circuit:
in a first operating mode, wherein said first amplifier (11) is active and said first splitter amplifier (100₁) in the first signal splitter (13₁, 100₁) is inactive wherein the at least one secondary signal splitter (13₂, 100₂, 13₃, 100₃, ..., 13_{N-1}, 100_{N-1}; 13₂, 100₂, ..., 13_{K}, 100_{K}, 300; 13₂, 100₂; 300) fails to receive said respective input signal coming from said first splitter amplifier (100₁) in the first signal splitter (13₁, 100₁); and
in at least one second operating mode, wherein both said first amplifier (11) and said first splitter amplifier (100₁) in the first signal splitter (13₁, 100₁) are active while said respective secondary amplifier (A₁, A₂, ...,A_{N-2}; A₁, ...,A_{K-1}, A_{K}; 21) and said respective further secondary amplifier (A_{N-1}; A_{K+1},..., A_{N-1}; 31) are activated at a respective back-off point.

11. The method of claim 10, wherein the at least one secondary signal splitter (13₂, 100₂; 13₃, 100₃; ...; 13_{N-1}, 100_{N-1}; 13₂, 100₂) comprises a passive splitter network (13₂, 13₃, ...; 13_{N-1}; 13₂) and a splitter amplifier (100₂, 100₃, ...,100_{N-1}; 100₂) coupled therewith, and said at least one second operating mode comprises activating said splitter amplifier (100₂, 100₃, ...,100_{N-1}; 100₂) in the at least one secondary signal splitter (13₂, 100₂; 13₃, 100₃; ...; 13_{N-1}, 100_{N-1}; 13₂, 100₂) in response to said respective secondary amplifier (A₁, A₂, ...,A_{N-2}; A₁,...,A_{K-1}, A_{K}; 21) and said respective further secondary amplifier (A_{N-1}; A_{K+1}, ..., A_{N-1}; 31) being activated at a respective back-off point.
